# EUROPEAN PATENT APPLICATION

(11) **EP 4 593 078 A1**
(43) Date of publication of application: **30.07.2025**
(21) Application number: 23867781.9
(22) Date of filing: 01.03.2023
(51) Int. Cl.: H01L 23/48, H01L 25/07, H01L 25/18

(54) **LAMINATE, METHOD FOR MANUFACTURING LAMINATE, AND CONDUCTIVE LAMINATE**

(30) Priority: 22.09.2022 WO PCT/JP2022/035543
(71) Applicant: Resonac Corporation, Tokyo 105-7325 (JP)
(72) Inventor: YAMAGUCHI, Yui, Tokyo 105-8518 (JP); FUJISAWA, Kazutake, Tokyo 105-8518 (JP); YAMASHITA, Takahiro, Tokyo 105-8518 (JP); ITO, Seiichi, Tokyo 105-8518 (JP); FUKUKAWA, YUJI, Tokyo 105-8518 (JP); SHODA, Hiroaki, Tokyo 105-8518 (JP)
(74) Representative: Berggren Oy
(86) International application number: PCT/JP2023/007697
(87) International publication number: WO 2024/062649

(57) **Abstract**

A layered body contains: a first resin layer; a first conductive layer;
an insulating layer; and a second conductive layer; in this order, in which the first resin layer comprises a storage portion, and the first conductive layer is disposed within the storage portion of the first resin layer. A conductive layered body contains: a first conductive layer; an insulating layer; and a second conductive layer; in this order, in which an adhesive layer is provided between the first conductive layer and the insulating layer, and between the insulating layer and the second conductive layer, respectively.

## Description

### Technical field

This disclosure relates to a layered body, a method of producing a layered body, and a conductive layered body.

### Background Art

Power modules (PMs) installed in hybrid vehicles and the like each include a layered body (also referred as a housing) including a resin molded product and a metal.

Conventionally, such housings are produced by arranging a conductive layer and an insulating layer in a mold, injecting a resin into the mold, and molding (hereinafter also called "insert molding").

### SUMMARY OF INVENTION

Normally, a heat-dissipating plate having an element brazed thereto is attached to the housing used in PMs.

From the viewpoint of improving production efficiency, it is desirable to simultaneously bond the heat-dissipating plate to the housing and the element to the heat-dissipating plate. However, brazing the elements to the heat-dissipating plate applies heat to the housing.

The present inventors have now discovered that in a housing produced by the conventional insert molding disclosed in Japanese Patent Application Laid-Open (JP-A) No. 2021-122959 (Patent Document 1), a conductive layer is embedded in a resin layer, and therefore when the layered body is left in a high-temperature environment or heated, an internal stress caused by the difference in the linear expansion coefficient between the conductive layer and the resin layer cannot be sufficiently alleviated, resulting in the occurrence of cracks and deformation of the conductive layer and the resin layer, and that there is room for improvement in the thermal durability.

The problem that an embodiment in the present disclosure aims to solve is to provide a layered body with excellent thermal durability, and a method of producing a layered body.

In addition, since a SiC-MOSFET used as power semiconductor element can achieve high-speed switching than a conventional Si-IGBT, in order to fully utilize its performance, it is necessary to reduce the surge voltage that increases in proportion to the switching speed. From this viewpoint, it is desirable to lower the inductance of internal wiring, and to reduce inductance, it is effective to arrange two conductive layers in parallel at a narrow pitch so that they cancel each other's inductance.

However, it has become clear that when two conductive layers are arranged in parallel at a narrow pitch, partial discharge easily occurs, and inductance is not effectively reduced.

Therefore, the problem that an embodiment in the present disclosure aims to solve is to provide a conductive layered body in which partial discharge is less likely to occur even when two conductive layers are arranged in parallel at a narrow pitch.

### Solution to Problem

<1> A layered body including, in this order:
   a first resin layer;
   a first conductive layer;
   an insulating layer; and
   a second conductive layer,
   in which the first resin layer includes a storage portion, and the first conductive layer is disposed within the storage portion of the first resin layer.
<2> The layered body according to <1>, in which the storage portion includes a concave portion or a convex-concave portion.
<3> The layered body according to <1>, in which the first conductive layer, the insulating layer and the second conductive layer are disposed within the storage portion of the first resin layer.
<4> The layered body according to <1> or <2>, in which an area of the storage portion of the first resin layer is equal to or greater than an area of the first conductive layer.
<5> The layered body according to any one of <1> to <4>, further including a second resin layer at an opposite side of the second conductive layer from the insulating layer.
<6> The layered body according to any one of <1> to <5>, further including an adhesive layer between the first conductive layer and the insulating layer, and between the insulating layer and the second conductive layer, respectively,
   in which the adhesive layer includes a resin that is solid in an environment of 25°C.
<7> The layered body according to any one of <1> to <6>, in which the first resin layer is a cured product of a resin composition including a thermosetting resin.
<8> The layered body according to <7>, in which the thermosetting resin includes an unsaturated polyester.
<9> The layered body according to any one of <1> to <8>, in which the first resin layer includes a fixing portion that fixes the first conductive layer, the insulating layer and the second conductive layer.
<10> A method of producing a layered body, the method including:
   preparing a first resin layer including a storage portion on at least one surface; and
   layering a first conductive layer, an insulating layer and a second conductive layer on a surface of the first resin layer,
   in which, in the layering, at least the first conductive layer is disposed within the storage portion of the first resin layer.
<11> A conductive layered body including, in this order:
   a first conductive layer;
   an insulating layer; and
   a second conductive layer,
   in which an adhesive layer is provided between the first conductive layer and the insulating layer, and between the insulating layer and the second conductive layer, respectively.
<12> The conductive layered body according to <11>, including a region at which a peripheral edge of the first conductive layer is located at an inner side relative to a peripheral edge of the second conductive layer,
   in which, in the region, an end of the adhesive layer at a side of the first conductive layer is aligned with an end of the first conductive layer, or is up to 10 mm longer than the end of the first conductive layer.
<13> The conductive layered body according to <11>, including a region at which a peripheral edge of the first conductive layer is located at an inner side relative to a peripheral edge of the second conductive layer,
   in which, in the region, an end of the adhesive layer at a side of the first conductive layer is aligned with an end of the insulating layer
<14> The conductive layered body according to <11>, including a region at which a peripheral edge of the first conductive layer is located at an inner side relative to a peripheral edge of the second conductive layer,
   in which, in the region, an end of the adhesive layer at a side of the first conductive layer is 20 mm or more longer than an end of the first conductive layer.
<15> The conductive layered body according to any one of <11> to <14>, in which the adhesive layer is further provided on at least a part of an end face of the insulating layer.
<16> The conductive layered body according to any one of <11> to <15>, including a region at which a peripheral edge of the first conductive layer is located at an inner side relative to a peripheral edge of the second conductive layer,
   in which, in the region, the adhesive layer is further provided on at least a part of an end face of the first conductive layer.
<17> The conductive layered body according to <11>, <15> or <16>, in which the insulating layer is further provided on an end face of at least one of the first conductive layer or the second conductive layer.
<18> The conductive layered body according to <17>, in which the insulating layer provided on the end face of at least one of the first conductive layer or the second conductive layer further extends to a part of the outer surface of the first conductive layer.
<19> The conductive layered body according to <11>, in which the insulating layer covers a periphery of the first conductive layer or the second conductive layer.
<20> The conductive layered body according to any one of <11> to <19>, further including a bent portion that bends in a thickness direction, in which an angle of the bent portion is greater than 90° and less than 180°.
<21> The conductive layered body according to any one of <11> to <20>, in which at least one of a side of the first conductive layer or a side of the second conductive layer includes a protruding portion protruding in a thickness direction, in which an angle of the protruding portion at a rising part is greater than 90° and less than 180°.

### Advantageous Effects of Invention

According to an embodiment in the present disclosure, it is possible to provide a layered body with excellent thermal durability, and a method of producing a layered body.

According to an embodiment in the present disclosure, it is possible to provide a conductive layered body in which partial discharge is less likely to occur even when two conductive layers are arranged in parallel at a narrow pitch.

### BRIEF DESCRIPTION OF DRAWINGS

FIG. 1 is a perspective view showing an embodiment of a layered body in the present disclosure.
FIG. 2 is a perspective view showing another embodiment of a layered body in the present disclosure.
FIG. 3 is a cross-sectional view taken along line A-A' in FIG. 1.
FIG. 4 is a cross-sectional view taken along line A-A' in FIG. 2.
FIG. 5 is a cross-sectional view showing another embodiment of the layered body in the present disclosure.
FIG. 6 is a perspective view showing an embodiment of a first resin layer included in a layered body in the present disclosure.
FIG. 7 is a perspective view showing an embodiment of a first resin layer included in the layered body in the present disclosure.
FIG. 8 is a perspective view showing another embodiment of the layered body in the present disclosure.
FIG. 9 is a schematic cross-sectional view of one embodiment of a first conductive layered body.
FIG. 10 is a schematic cross-sectional view of one embodiment of a second conductive layered body.
FIG. 11 is a schematic cross-sectional view of one embodiment of a layered body using the second conductive layered body.
FIG. 12 is a schematic cross-sectional view of one embodiment of a third conductive layered body.
FIG. 13 is a schematic cross-sectional view of one embodiment of a fourth conductive layered body.
FIG. 14 is a c schematic cross-sectional view of another embodiment of the fourth conductive layered body.
FIG. 15 is a schematic cross-sectional view of another embodiment of the fourth conductive layered body.
FIG. 16 is a schematic cross-sectional view of one embodiment of a fifth conductive layered body.
FIG. 17 is a schematic cross-sectional view of one embodiment of a sixth conductive layered body.
FIG. 18 is a schematic cross-sectional view of one embodiment of a seventh conductive layered body.

### DESCRIPTION OF EMBODIMENTS

Hereinafter, embodiments for carrying out the present disclosure will be described in detail. However, the present disclosure is not limited to the following embodiments. In the following embodiments, the constituent elements (including element steps and the like) are not essential unless specifically stated otherwise. The same applies to numerical values and their ranges, and the present disclosure is not limited thereto.

In the present disclosure, the term "process" includes not only a process that is independent of other processes but also a process that, even if it cannot be clearly distinguished from another process, is encompassed so long as the purpose of that process is achieved.

In the present disclosure, in a numerical range indicated by "to", the numerical values described before and after "to" are respectively included as the minimum and maximum values.

In a stepwise numerical range described in the present disclosure, an upper or lower limit value described in one numerical range may be redisposed with the upper or lower limit value of another stepwise numerical range.

In addition, in a numerical range described in the present disclosure, the upper or lower limit value of that numerical range may be redisposed with the values i shown in the examples.

In the present disclosure, each component may include a plurality of types of the corresponding substance. When multiple types of substances corresponding to each component are present in a composition, unless otherwise specified, the content or amount of each component means the total content or amount of the multiple substances present in the composition.

In the present disclosure, the term "layer" includes not only the case where, when observing the region in which the layer is present, the layer is formed over the entire region, but also the case where the layer is formed only on part of that region.

In the present disclosure, when describing an embodiment with reference to the drawings, the configuration of the embodiment is not limited to the configuration shown in the drawings. In addition, the size of each member in the figures is conceptual, and the relative sizes of the members are not limited thereto.

### [LAYERED BODY]

A layered body in the present disclosure includes a first resin layer, a first conductive layer, an insulating layer, and a second conductive layer in this order, in which the first resin layer includes a storage portion, and the first conductive layer is disposed within the storage portion of the first resin layer.

The layered body of the present disclosure has excellent thermal durability. While the reason why the above effect is achieved is not clear, it is presumed as follows.

The layered body in the present disclosure can be produced by separately preparing each layer and then stacking them, rather than by insert molding. Therefore, in a layered body produced by insert molding, the first resin layer is embedded in the first conductive layer and is adhered to it. **In** contrast, in the layered body in the present disclosure, because the first resin layer has the storage portion, it is not in complete close contact with the first conductive layer, and thus the internal stress generated during heating can be relieved. As a result, it is presumed that the occurrence of cracks and the deformation of the conductive layer and resin layer can be suppressed, thereby improving heat durability.

Furthermore, the first resin layer has the storage portion, which is difficult to form by insert molding, and it is presumed what leads to improved thermal durability.

The layered body in the present disclosure may further include a second resin layer at an opposite side of the second conductive layer from the insulating layer.

The layered body in the present disclosure may include an adhesive layer between the first conductive layer and the insulating layer, and between the insulating layer and the second conductive layer, respectively.

The layered body in the present disclosure may include an adhesive layer between the first resin layer and the first conductive layer, and between the second conductive layer and the second resin layer, respectively.

From the viewpoint of thermal durability, it is preferable that the adhesive layer provided between the first resin layer and the first conductive layer is disposed within the storage portion of the first resin layer.

The layered body in the present disclosure may include a heat-dissipating plate on or above a surface at a side of the first resin layer of the first conductive layer, or on or above a surface at a side of the second resin layer of the second conductive layer.

From the viewpoint of thermal durability, it is preferable that the heat-dissipating plate is disposed within the storage portion of the first resin layer.

### (First resin layer)

The first resin layer has a storage portion, and the first conductive layer is disposed within the storage portion.

From the viewpoint of thermal durability, it is preferable that the storage portion includes a concave portion or a convex-concave portion.

What is meant by the storage portion including a convex-concave portion is that the storage portion includes a concave portion and a convex portion. The concave portion may be step-shaped, having a deeper concave portion provided on the inside.

From the viewpoint of thermal durability, it is preferable that the first conductive layer, the insulating layer and the second conductive layer are disposed within the storage portion of the first resin layer.

**In** a case in which the storage portion includes a step-shaped concave portion, the first conductive layer, the insulating layer and the second conductive layer may be accommodated in the same level or in different levels.

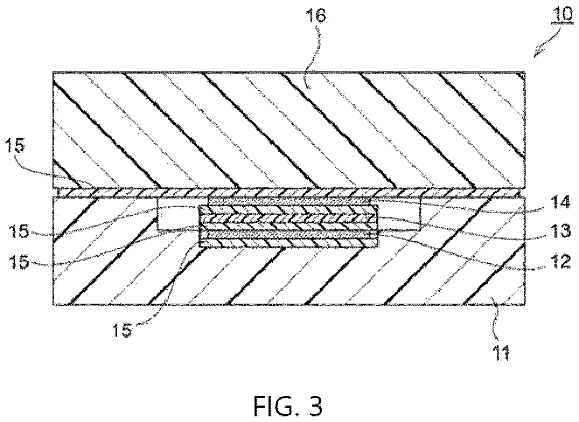

FIGS 3 to 5 show an embodiment in which the first conductive layer, the insulating layer and the second conductive layer are accommodated in different levels of a-shaped concave portion.

**In** addition, the first resin layer may have only one storage portion or may have two or more storage portions.

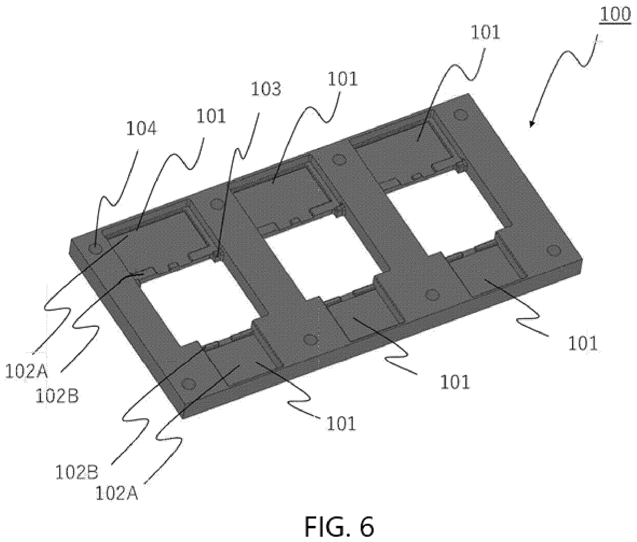

FIG. 6 shows a first resin layer 100 having a plurality of storage portions 101.

Each storage portion 101 of the first resin layer 100 shown in FIG. 6 includes a concave portion 102A and a convex portion 102B that is higher than the concave portion 102A.

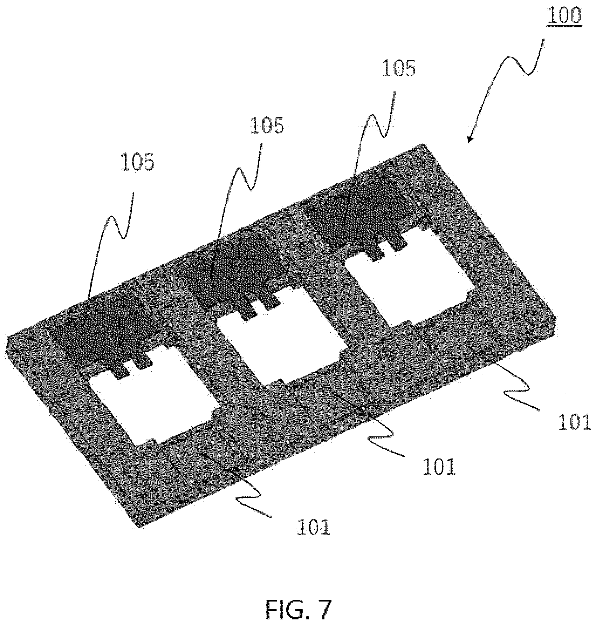

In a case in which the first resin layer has a plurality of storage portions, the first conductive layer 105 may be disposed in some of the storage portions as shown in FIG. 7, or the first conductive layer 105 may be disposed in all of the storage portions.

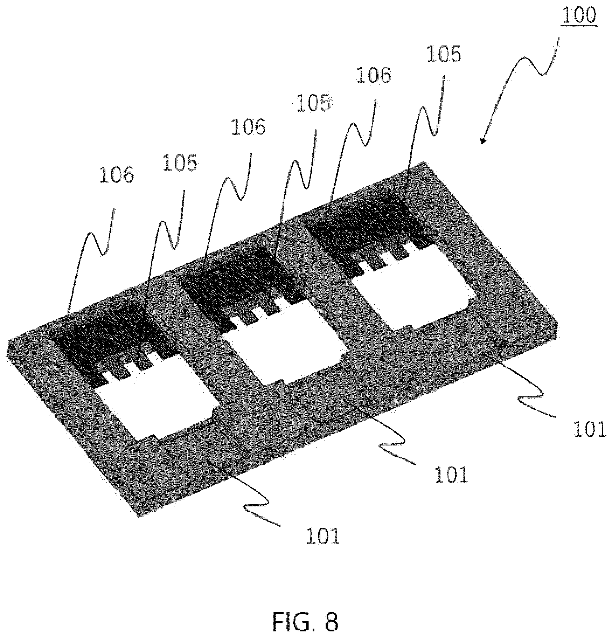

The insulating layer and the second conductive layer may not be layered on all of the first conductive layers disposed in the storage portions, but may be layered on all of the first conductive layers disposed in the storage portions as shown in FIG. 8. In FIG. 8, the insulating layer is not shown, and the second conductive layer is indicated by the reference numeral 106.

An area of the storage portion of the first resin layer is preferably equal to or larger than an area of the first conductive layer. A ratio of the area of the first conductive layer to the area of the storage portion of the first resin layer (area of first conductive layer/storage portion of first resin layer) is preferably 1.01 or more. Thus, the placement of the first conductive layer into the storage portion of the first resin layer can be carried out more easily. The ratio of the area is preferably 2.00 or less. As a result, there is a tendency to suppress the occurrence of positional shifts of the first conductive layer on the first resin layer.

In a case in which the first resin layer has the storage portion, a size of the storage portion is preferably changed as appropriate depending on a size of the first conductive layer, the use of the layered body, and the like. The area of the storage portion may be, for example, from 1 cm² to 1,000 cm².

A depth of the storage portion is preferably at least equal to or greater than a thickness of the first conductive layer, more preferably equal to or greater than a sum of the thicknesses of the first conductive layer, the insulating layer and the second conductive layer, even more preferably equal to or greater than a sum of the thicknesses of the first conductive layer, the insulating layer, the second conductive layer and the adhesive layer, and particularly preferably equal to or greater than a sum of the thicknesses of the first conductive layer, the insulating layer, the second conductive layer, the adhesive layer and the heat-dissipating plate. The depth of the storage portion may be, for example, from 0.1 mm to 100 mm.

The depth of the storage portion may be less than a sum of the thicknesses of the first conductive layer, the insulating layer, the second conductive layer, the adhesive layer and the heat-dissipating plate.

From the viewpoint of thermal durability, the first resin layer is preferably a cured product of a resin composition containing a thermosetting resin.

The type of thermosetting resin is not particularly limited, and may be any resin having at least one functional group in each molecule that can be used in a crosslinking reaction by heating. Examples of the functional group include an epoxy group, an acryloyl group, a methacryloyl group, a hydroxy group, a vinyl group, a carboxy group, an amino group, a maleimide group, an acid anhydride group, a thiol group, a thionyl group, an amide group, and an imide group.

Examples of the thermosetting resin include a phenolic resin, an unsaturated imide resin, a cyanate resin, an isocyanate resin, a benzoxazine resin, an oxetane resin, an amino resin, an unsaturated polyester resin, an acrylic resin, a dicyclopentadiene resin, a silicone resin, a triazine resin, a melamine resin, a resorcinol resin, and an epoxy resin. Among the above, from the viewpoint of thermal durability, it is preferable to include at least one selected from an unsaturated polyester and a phenolic resin, and it is more preferable to include an unsaturated polyester.

The resin composition may contain one type of thermosetting resin alone, or two or more types thereof.

The unsaturated polyester may be obtained by polycondensation (esterification) of a polyhydric alcohol with an unsaturated polybasic acid, a saturated polybasic acid or the like.

The polyhydric alcohol is not particularly limited, and any conventionally known one may be used. Examples of the polyhydric alcohol include ethylene glycol, propylene glycol, butanediol, diethylene glycol, dipropylene glycol, triethylene glycol, pentanediol, hexanediol, neopentanediol, hydrogenated bisphenol A, bisphenol A, and glycerin. These may be used singly or in combination of two or more kinds.

The unsaturated polybasic acid is not particularly limited, and any conventionally known one may be used. Examples of the unsaturated polybasic acid include maleic anhydride, fumaric acid, citraconic acid, and itaconic acid. These may be used singly or in combination of two or more kinds.

The saturated polybasic acid is not particularly limited, and any conventionally known one may be used. Examples of the saturated polybasic acid include phthalic anhydride, isophthalic acid, terephthalic acid, HET acid, succinic acid, adipic acid, sebacic acid, tetrachlorophthalic anhydride, tetrabromophthalic anhydride, and endomethylene tetrahydrophthalic anhydride. These may be used singly or in combination of two or more kinds.

The unsaturated polyester may be one synthesized by a known method using the above raw materials, or a commercially available one may be used.

The unsaturated polyester may be obtained by polycondensing a polyhydric alcohol with an unsaturated polybasic acid, a saturated polybasic acid or the like, at a temperature from 140°C to 230°C in an atmosphere of an inert gas such as nitrogen. The polycondensation reaction may be carried out under pressurized or reduced-pressure conditions.

In the polycondensation reaction, a crosslinking agent and a catalyst may be used as necessary.

Examples of the crosslinking agent include styrene monomer, diallyl phthalate monomer, diallyl phthalate prepolymer, methyl methacrylate, and triallyl isocyanurate. These may be used singly or in combination of two or more kinds.

Examples of the catalyst include manganese acetate, dibutyltin oxide, stannous oxalate, zinc acetate, and cobalt acetate. These may be used singly or in combination of two or more kinds.

From the viewpoint of thermal durability, a number average molecular weight of the thermosetting resin is preferably from 1,000 to 10,000, and more preferably from 1,500 to 5,000.

In the present disclosure, a number average molecular weight is a polystyreneequivalent weight-average molecular weight measured by gel permeation chromatography (GPC).

From the viewpoint of thermal durability, a content of the thermosetting resin with respect to a total mass of the resin composition is preferably from 10% by mass to 60% by mass, more preferably from 20% by mass to 50% by mass, and even more preferably from 20% by mass to 40% by mass.

The resin composition may contain a thermoplastic resin, an elastomer, or the like. Specific examples of the thermoplastic resin include polyimide resin, polyamideimide resin, polyamide resin, polyetherimide resin, polybenzoxazole resin, polybenzimidazole resin, polystyrene resin, acrylonitrile-butadiene-styrene copolymer resin, acrylonitrile-styrene copolymer resin, polyethylene resin, polypropylene resin, polyvinyl chloride resin, polyvinylidene chloride resin, polycarbonate resin, (meth)acrylic resin, polyester resin, polyacetal resin, and polyphenylene sulfide resin (PPS).

Specific examples of the elastomer include silicone rubber, styrene butadiene rubber (SBR), nitrile rubber (NBR), and urethane rubber.

The resin composition may contain various additives such as a curing agent, a curing accelerator, a filler, a release agent, a flame retardant, a colorant, a plasticizer, a silane coupling agent, an anti-rust agent, a copper damage inhibitor, a reducing agent, an antioxidant, a tackifier resin, an ultraviolet absorber, an antifoaming agent, a leveling adjuster, and a solvent.

The first resin layer may have a fixing portion that fixes the first conductive layer, the insulating layer and the second conductive layer. In a case in which the first resin layer has the fixing portion, there in tendency to suppress the occurrence of misalignment of the first conductive layer, the insulating layer and the second conductive layer on the first resin layer.

The first resin layer and the second resin layer may each have either an insertion portion or an opening portion.

In a case in which the first resin layer has either an insertion portion or an opening portion and the second resin layer has at least the other thereof, the first resin layer and the second resin layer may be fitted together by inserting the insertion portion into the opening portion.

### (First conductive layer and Second conductive layer)

The first conductive layer and the second conductive layer may contain at least one of a metal and a metal oxide.

Examples of the metal include silver, gold, copper, palladium, platinum, titanium, chromium, nickel, aluminum, zirconium, tungsten, vanadium, rhodium, iridium, and alloys of these.

Examples of the metal oxide include zinc oxide (ZnO), tin oxide (SnO₂), indium tin oxide (ITO), aluminum oxide (Al₂O₃), and titanium oxide (TiO₂).

From the viewpsoint of conductivity, an average thickness of the first conductive layer and the second conductive layer may be suitably set according to their intended use. Considering ease of placement into the concave portion or concave-convex portion of the first resin layer, it is preferable that the average thickness is from 0.1 mm to 10 mm.

In the present disclosure, the average thickness refers to the average of thicknesses measured at two points in the layer using a measuring instrument.

The materials, average thicknesses and the like of the layers that the first conductive layer and the second conductive layer include may be the same or different.

### (Insulating layer)

The insulating layer is preferably a cured product of a resin composition containing an insulating resin.

Examples of the insulating resin may be a thermoplastic resin, a curable resin such as a thermosetting resin and a photocurable resin.

The photocurable resin may be any resin that has at least one unsaturated bond in each molecule and undergo crosslinking reaction upon exposure to light. Specific examples of the photocurable resin include acrylic resin, urethane resin, polyester resin, polyether resin, epoxy resin, polybutadiene resin, polyimide resin, polyamide resin, silicone resin, and fluororesin.

Thermoplastic resins and thermosetting resins have already been described above, therefore a detailed description is omitted here.

The resin composition may contain various additives such as a curing agent, a curing accelerator, a photopolymerization initiator, a filler, a release agent, a flame retardant, a colorant, a plasticizer, a silane coupling agent, an anti-rust agent, a copper damage inhibitor, a reducing agent, an antioxidant, a tackifier resin, an ultraviolet absorber, an antifoaming agent, a leveling adjuster, and a solvent.

From the viewpoint of insulation, an average thickness of the insulating layer may be suitably set according to their intended use. Considering ease of placement into the concave portion or concave-convex portion of the first resin layer, it is preferable that the average thickness is from 0.01 mm to 10 mm.

### (Second resin layer)

The layered body in the present disclosure may further include a second resin layer at an opposite side of the second conductive layer from the insulating layer. By providing the second resin layer, there is tendency to suppress positional shifts of of the first conductive layer, the insulating layer and the second conductive layer on the first resin layer.

The second resin layer may have a concave portion, a convex portion, or a convex-concave portion. The concave portion, the convex portion or the convex-concave portion provided in the second resin layer may be provided in correspondence to the shape of the second conductive layer. By the correspondence between the concave portion of the second resin layer and the shape of the second conductive layer, the position of the second conductive layer may be fixed by the second resin layer.

For example, in a case in which a total thickness of the first conductive layer, the insulating layer and the second conductive layer is greater than a depth of the concave portion of the first resin layer, a concave portion corresponding to the shape of the second conductive layer may be provided in the second resin layer. In this case, it is preferable that an area of the concave portion of the second resin layer is equal to or greater than an area of the second conductive layer.

Meanwhile, in a case in which a total thickness of the first conductive layer, the insulating layer and the second conductive layer is smaller than a depth of the concave portion of the first resin layer, a convex portion corresponding to the position of the second conductive layer may be provided in the second resin layer. There may be one convex portion or a plurality of convex portions.

The second resin layer is preferably a cured product of a resin composition containing a thermosetting resin. The thermosetting resin and the resin composition have already been described above, and therefore a detailed description thereof is omitted here.

The second resin layer may have a fixing portion that fixes the first conductive layer, the insulating layer and the second conductive layer. In a case in which the second resin layer have a fixing portion, there is tendency to suppress positional shifts of the first conductive layer, the insulating layer and the second conductive layer on the first resin layer.

### (Adhesive layer)

The layered body in the present disclosure may include an adhesive layer between the first conductive layer and the insulating layer, and between the insulating layer and the second conductive layer, respectively.

The layered body in the present disclosure may include an adhesive layer between the first resin layer and the first conductive layer, and between the second conductive layer and the second resin layer, respectively.

By adjusting a size of the adhesive layer provided between any of these layers, the first resin layer and the second resin layer may be bonded together.

The adhesive layer preferably contains a resin that is solid in an environment of 25°C. Thus, it possible to suppress changes in the thickness of the adhesive layer when stacking the first conductive layer, adhesive layer, insulating layer and the like on the surface of the first resin layer, and thereby suppressing changes in the distance between the first conductive layer and the insulating layer, the distance between the first conductive layer and the second conductive layer, the distance between the second conductive layer and the insulating layer, and the like.

Examples of the resin that is solid in an environment of 25°C include polyimide resin, polyamideimide resin, polyamide resin, polyetherimide resin, polybenzoxazole resin, polybenzimidazole resin, polystyrene resin, acrylonitrile-butadiene-styrene copolymer resin, acrylonitrile-styrene copolymer resin, polyethylene resin, polypropylene resin, polyvinyl chloride resin, polyvinylidene chloride resin, polycarbonate resin, (meth)acrylic resin, polyester resin, polyacetal resin, polyphenylene sulfide resin (PPS), and phenolic resin.

The resin that is solid in an environment of 25°C is preferably a thermoplastic resin. An adhesive layer containing a thermoplastic resin may be bonded by heating. Furthermore, for example, even if one side of an adhesive layer containing a thermoplastic resin is bonded to the first conductive layer and then cooled so that the adhesive layer returns to a solid state, the insulating layer may still be bonded to the other side of the adhesive layer by heating it again, thus providing excellent workability.

A content of the resin that is solid in an environment of 25°C with respect to a total mass of the adhesive layer is preferably from 10% by mass to 100% by mass, and more preferably from 60% by mass to 80% by mass.

The adhesive layer may contain various additives such as a filler, a release agent, a flame retardant, a colorant, a plasticizer, a silane coupling agent, an anti-rust agent, a copper damage inhibitor, a reducing agent, an antioxidant, a tackifier resin, an ultraviolet absorber, an antifoaming agent, a leveling adjuster, and a solvent.

From the viewpoint of adhesion, an average thickness of the adhesive layer is preferably from 1 µm to 5,000 µm, more preferably from 20 µm to 1,000 µm, and even more preferably from 50 µm to 800 µm.

### (Heat-Dissipating Plate)

The layered body in the present disclosure may be provided with a heat-dissipating plate on or above a surface at a side of the first resin layer of the first conductive layer, or on or above a surface at a side of the second resin layer of the second conductive layer.

As the heat-dissipating plate, any conventionally known one can be used, and an element or the like may be bonded thereto.

### (Uses)

The layered body in the present disclosure may be suitably used for the production of a power module (PM).

The use of the layered body in the present disclosure is not limited to PM applications, and the layered body in the present disclosure may be used for other electrical components, control system components, drive system components, low-current related components, home appliances, decorative parts, and the like.

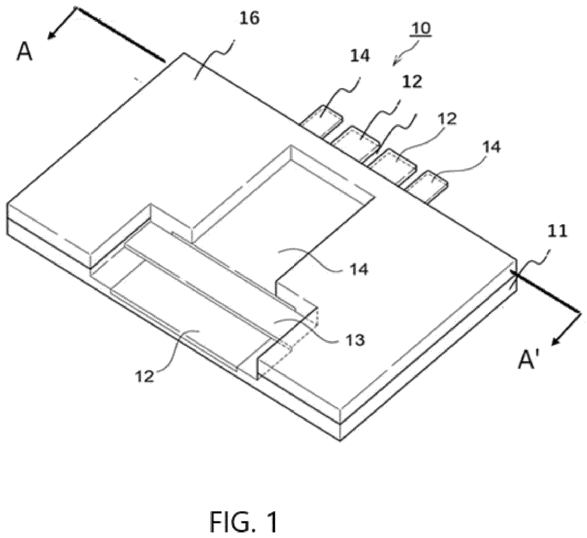

Hereinafter, one embodiment of the layered body and the like of the present disclosure will be described with reference to FIGS. 1 to 6. However, the disclosed layered body is not limited to the forms shown in FIGS. 1 to 6.

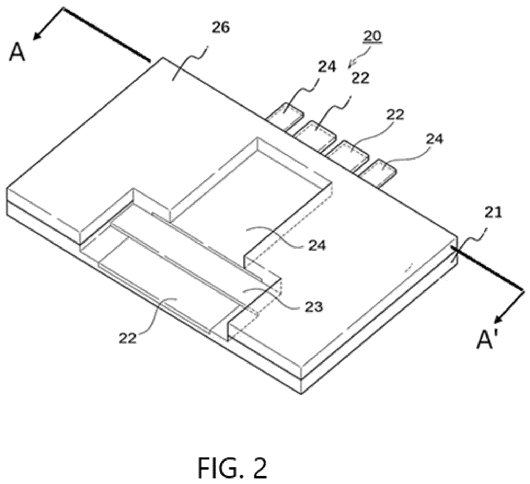

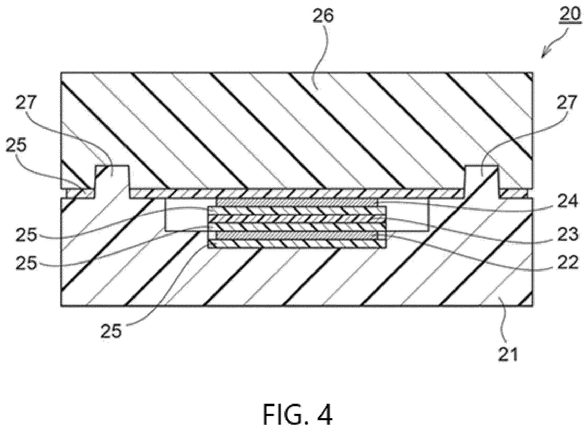

FIG. 1 is a perspective view showing an embodiment of the layered body in the present disclosure, and FIG. 3 is a cross-sectional view thereof. FIG. 2 is a perspective view showing another embodiment of the layered body in the present disclosure, and FIG. 4 is a cross-sectional view thereof. In FIGS. 1 and 2, the depiction of adhesive layers between layers is omitted.

The layered body 10 shown in FIG. 1 includes a first resin layer 11, a first conductive layer 12, an insulating layer 13, a second conductive layer 14, and a second resin layer 16, in this order.

The layered body 20 shown in FIG. 2 includes a first resin layer 21, a first conductive layer 22, an insulating layer 23, a second conductive layer 24, and a second resin layer 26, in this order.

As shown in FIGS. 1 and 2, the second resin layer may have an opening. This allows placement of a heat-dissipating plate or the like on the surface of the second conductive layer or the like. A shape of the opening is not particularly limited, and is preferably adjusted appropriately depending on the application.

As shown in FIGS. 1 and 2, the first conductive layer and the second conductive layer may protrude outward from the outer periphery of the first resin layer and the second resin layer. This allows connection to another member such as wiring.

The layered body 30 shown in FIG. 3 includes a first resin layer 11, an adhesive layer 15, a first conductive layer 12, an adhesive layer 15, an insulating layer 13, an adhesive layer 15, a second conductive layer 14, an adhesive layer 15, and a second resin layer 16. The adhesive layers 15 provided between the layers may the same or different in material.

As shown in FIG. 3, the first resin layer 11 has a storage portion including a step-shaped concave portion, and inside the storage portion are disposed the adhesive layer 15, the first conductive layer 12, the adhesive layer 15, the insulating layer 13, the adhesive layer 15, the second conductive layer 14, and the adhesive layer 15.

In FIG. 3, the first conductive layer 12, the insulating layer 13, and the second conductive layer 14 are accommodated at different levels of a step-shaped concave portion. This is presumed to improve thermal durability.

In the layered body 30 shown in FIG. 3, the first resin layer 11 and the second resin layer 16 are bonded by the adhesive layer 15.

The layered body 20 shown in FIG. 4 includes a first resin layer 21, an adhesive layer 25, a first conductive layer 22, an adhesive layer 25, an insulating layer 23, an adhesive layer 25, a second conductive layer 24, an adhesive layer 25, and a second resin layer 26. The adhesive layers 25 provided between the layers may be the same or different in material.

As shown in FIG. 4, the first resin layer 21 has a storage portion including a step-shaped concave portion, and inside the storage portion are disposed the adhesive layer 25, the first conductive layer 22, the adhesive layer 25, the insulating layer 23, the adhesive layer 25, the second conductive layer 24, and the adhesive layer 25.

In FIG. 4, the first conductive layer 22, the insulating layer 23, and the second conductive layer 24 are accommodated at different levels of a step-shaped concave portion. This is presumed to improve thermal durability.

In addition, as shown in FIG. 4, the first resin layer 21 has an insertion portion 27, which is inserted into an opening portion (not shown) of the second resin layer 26. The insertion portion 27 may be provided at any position as long as it can be inserted into the second resin layer 26.

In the layered body 20 shown in FIG. 4, the first resin layer 21 and the second resin layer 26 are bonded by the adhesive layer 25.

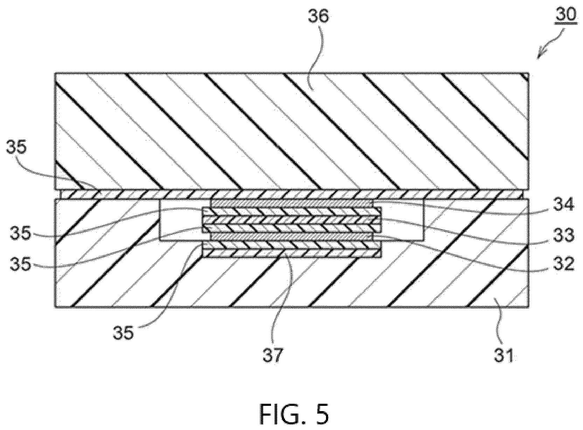

FIG. 5 is a cross-sectional view showing another embodiment of the layered body in the present disclosure.

The layered body 30 shown in FIG. 5 includes a first resin layer 31, a heat-dissipating plate 37, an adhesive layer 35, a first conductive layer 32, an adhesive layer 35, an insulating layer 33, an adhesive layer 35, a second conductive layer 34, an adhesive layer 35, and a second resin layer 36. The adhesive layers 35 provided between the layers may be the same or different in material.

As shown in FIG. 5, the first resin layer 31 has a storage portion including a step-shaped concave portion, and inside the storage portion are disposed the heat-dissipating plate 37, the adhesive layer 35, the first conductive layer 32, the adhesive layer 35, the insulating layer 33, the adhesive layer 35, the second conductive layer 34 and the adhesive layer 35.

In FIG. 5, the first conductive layer, the insulating layer and the second conductive layer are s accommodated at different levels of the step-shaped concave portion. This is presumed to improve thermal durability.

In addition, in the layered body 30 shown in FIG. 5, the first resin layer 31 and the second resin layer 36 are bonded by the adhesive layer 35.

FIG. 6 is a perspective view showing an embodiment of a first resin layer included in the layered body in the present disclosure.

As shown in FIG. 6, the first resin layer 100 has a plurality of storage portions 101, and each storage portion 101 includes a concave portion 102A and a convex portion 102B.

Additionally, the first resin layer 100 also has a fixing portion 103 and an opening portion 104.

As shown in FIG. 6, the first resin layer 100 may have the opening potion between the storage portions 101. This allows connection of another member such as wiring to the first conductive layer 32 or the like disposed on the first resin layer 100 through the opening portion.

As shown in FIGS. 3 to 6, the outer peripheries of the adhesive layer, the first conductive layer, the insulating layer and the second conductive layer may be different in size. In a case in which the outer peripheries of the adhesive layer, the first conductive layer, the insulating layer and the second conductive layer are different in size, it is preferable that an inner periphery of the concave portion of the first resin layer is equal to or larger than an outer periphery of the layer having the largest outer periphery among the adhesive layer, the first conductive layer, the insulating layer, and the second conductive layer.

### [METHOD OF PRODUCING LAYERED BODY]

A method of producing a layered body in the present disclosure includes: preparing a first resin layer including a storage portion on at least one surface; and layering a first conductive layer, an insulating layer and a second conductive layer on a surface of the first resin layer, in which, in the layering, at least the first conductive layer is disposed within the storage portion of the first resin layer.

According to the method of producing a layered body in the present disclosure, a layered body having excellent thermal durability can be produced. While the reason why the above effect is achieved is not clear, it is presumed as follows.

The layered body of the present disclosure is produced by preparing each layer separately and layering them, rather than by insert molding. Therefore, whereas in a layered body produced by insert molding, the first conductive layer is embedded in the first resin layer and is completely adhered to it, in a layered body produced by the producing method in the present disclosure, the first resin layer and the first conductive layer are not in complete close contact, thereby allowing relaxation of internal stress that arises during heating. As a result, it is presumed that the occurrence of cracks, as well as deformation of the conductive layer and resin layer, can be suppressed, and that thermal durability is improved.

The method of producing a layered body in the present disclosure may include secondary layering of further layering second resin layer at an opposite side of the second conductive layer from the insulating layer.

### (Preparing)

Since the first resin layer has been described above, its explanation is omitted here.

The method for producing the first resin layer is not particularly limited, and it can be produced by injection molding or the like.

### (Layering)

The method of producing a layered body in the present disclosure includes layering a first conductive layer, an insulating layer and a second conductive layer on a surface of the first resin layer.

In the layering, at least the first conductive layer is disposed in the storage portion of the first resin layer. It is preferable that the first insulating layer and the second conductive layer be disposed in the storage portion of the resin layer.

When layering the first conductive layer, the insulating layer and the second conductive layer on the surface of the first resin layer, an adhesive layer may be disposed between each layer. In a case in which the adhesive layer contains a thermoplastic or thermosetting resin, it can be bonded by heating.

In a case in which an adhesive layer is disposed between each layer, in layering, it is preferable to dispose the adhesive layer in the storage portion of the first resin layer together with the first conductive layer, the insulating layer, and the second conductive layer.

In the lamination process, a heat-dissipating plate may be disposed on the side of the first conductive layer opposite the insulating layer, or on the side of the second conductive layer opposite the insulating layer.

In a case in which a heat-dissipating plate is disposed, in layering, it is preferable to dispose the heat-dissipating plate in the storage portion of the first resin layer together with the first conductive layer, insulating layer, and second conductive layer.

Since the first conductive layer, the second conductive layer, the insulating layer, the adhesive layer and the heat-dissipating plate have been described above, their explanation is omitted here.

The first conductive layer, the second conductive layer, the insulating layer, the adhesive layer, and the heat-dissipating plate may be those produced by a conventionally known method, or may a commercially available product may be used.

### (Secondary layering)

Since the second resin layer has been described above, its explanation is omitted here.

The method of producing the second resin layer is not particularly limited, and it can be produced by injection molding or the like.

When layering the second resin layer, an adhesive layer may be disposed between the second resin layer and the second conductive layer. In a case in which the adhesive layer contains a thermoplastic or thermosetting resin, it can be bonded by heating.

The first resin layer and the second resin layer may also be bonded by an adhesive layer.

In a case in which the first resin layer has either an insertion portion or an opening portion and the second resin layer has at least the other thereof, the first resin layer and the second resin layer may be fitted together by inserting the insertion portion into the opening portion.

### [CONDUCTIVE LAYERED BODY]

The conductive layered body in the present disclosure contains, in this order: a first conductive layer; an insulating layer; and a second conductive layer, in which an adhesive layer is provided between the first conductive layer and the insulating layer, and between the insulating layer and the second conductive layer, respectively.

Conventionally, the first conductive layer, the insulating layer, and the second conductive layer have been layered in this order without an adhesive layer. In this case, air enters between the first conductive layer and the insulating layer, as well as between the insulating layer and the second conductive layer, causing partial discharge to occur, thus, the distance (gap) between them has been widened some extent in order to suppress the occurrence of partial discharges. As a result, it was not possible to narrow the gap between the first conductive layer and the insulating layer, and between the insulating layer and the second conductive layer.

In contrast, in the conductive layered body with the above configuration, an insulating layer is disposed via an adhesive layer between the first conductive layer and the second conductive layer, thereby allowing the first conductive layer and the second conductive layer to run in parallel with a narrow gap. In this layer configuration, even if voids are contained within the adhesive layer, the voids can be reduced by applying pressure in the thickness direction, and partial discharge caused by voids can be suppressed.

The first conductive layer, the second conductive layer, and the insulating layer are the same as the first conductive layer, the second conductive layer, and the insulating layer in the above-described layered body. The first conductive layer and the second conductive layer may be bus bars. The first conductive layer may be a P bus bar or an N bus bar, and its counterpart second conductive layer may be the opposite N bus bar or a P bus bar.

Because the conductive layered body in the present disclosure sufficiently suppresses partial discharge, a layered body that houses the conductive layered body inside by separately producing in advance the first resin layer and further the second resin layer as described above, then stacking them. Alternatively, one may perform insert molding using the conductive layered body in the present disclosure and thereby producing a layered body that houses the conductive layered body.

Hereinafter, preferred embodiments of the conductive layered body in the present disclosure will be exemplified, however, the conductive layered body in the present disclosure is not limited to these embodiments.

### <First conductive layered body>

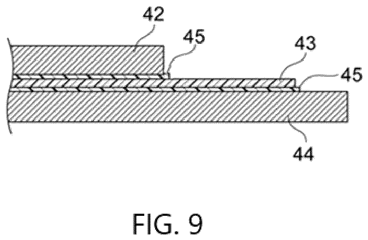

In the first conductive layered body, there is a region at which a peripheral edge of the first conductive layer is located at an inner side relative to a peripheral edge of the second conductive layer, in which, in the region, an end of the adhesive layer at a side of the first conductive layer is aligned with an end of the first conductive layer, or is up to 10 mm longer than the end of the first conductive layer. FIG. 9 is a schematic cross-sectional view of one embodiment of the first conductive layered body.

In the region where the first conductive layer 42 is disposed, even if the adhesive layer 45 contains voids, they can be reduced by applying pressure from the outside of the first conductive layer 42 in the thickness direction. On the other hand, since the adhesive layer 45 that protrudes from the end of the first conductive layer 42 is not subjected to such pressing, it is difficult to reduce voids there, which can lead to partial discharge. Hence, it is preferable that the end of the adhesive layer at a side of the first conductive layer does not protrude as much as possible from the end of the first conductive layer.

In FIG. 9, the end of the adhesive layer 45 on the first conductive layer 42 side protrudes beyond the end of the first conductive layer 42, but the protrusion length is preferably within 10 mm, more preferably within 3 mm, even more preferably within 1 mm, and particularly preferably within 0.5 mm, and it is extremely preferable that the end of the adhesive layer 45 on the first conductive layer 42 side be aligned with the end of the first conductive layer 42.

In FIG. 9, the second conductive layer 44 is longer than the insulating layer 43, but it may also be made the same length as the insulating layer 43. In the first conductive layered body, a length of the adhesive layer 45 on the side of the second conductive layer 44 is not particularly limited, it may be aligned with the end of the insulating layer 43, or with the end of the second conductive layer 44, or it may be longer than the insulating layer 43 and shorter than the second conductive layer 44.

In the case of the first conductive layered body, from the viewpoint of preventing discharge from the end of the first conductive layer 42 around the end of the insulating layer 43 to the second conductive layer 44, it is preferable that the distance from the end of the first conductive layer 42 to the end of the insulating layer 43 be sufficiently large, and more preferably, for example, 20 mm or more.

In FIG. 9, the first conductive layer 42 is shown as being shorter than the second conductive layer 44, but the first conductive layer 42 and the second conductive layer 44 may be reversed. In such a case, it is preferable that the end of the adhesive layer 45 on the second conductive layer 44 side be either aligned with the end of the second conductive layer 44 or is longer than the end of the second conductive layer 44 by 10 mm or less.

In the first conductive layered body, the adhesive layer 45 may be further provided on at least a part of an end face of the insulating layer 43.

### <Second conductive layered body>

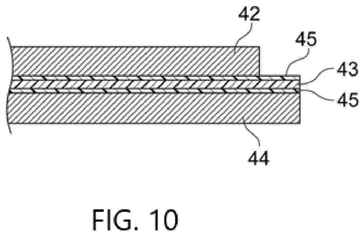

In the second conductive layered body, there is a region in which the peripheral edge of the first conductive layer lies further inward than the peripheral edge of the second conductive layer, and in the region, the end of the adhesive layer on the side of the first conductive layer is aligned with the end of the insulating layer. FIG. 10 is a schematic cross-sectional view of one embodiment of the second conductive layered body.

In FIG. 10, the length of the second conductive layer 44 is aligned with the length of the insulating layer 43, but it may also be longer than the insulating layer 43. **In** the second conductive layered body, the length of the adhesive layer 45 on the side of the second conductive layer 44 is not particularly limited, and it may be aligned with the end of the insulating layer 43, or with the end of the second conductive layer 44, or it may be longer than the insulating layer 43 and shorter than the second conductive layer 44.

In FIG. 10, the first conductive layer 42 is shown to be shorter than the second conductive layer 44, but the first conductive layer 42 and the second conductive layer 44 may be reversed such that the second conductive layer 44 is shorter than the first conductive layer 42.

In the second conductive layered body, the adhesive layer 45 may be further provided on at least a part of the end face of the insulating layer 43.

Because in the first conductive layered body, the protruding length of the adhesive layer 45 on the side of the first conductive layer 42 is shorter than that in the second conductive layered body, it is easier to achieve the function of preventing partial discharge. However, since in the conventional manner the conductive layer and the insulating layer are provided without using an adhesive layer, partial discharge is suppressed more than in the prior art even if the gap between the conductive layer and insulating layer is narrowed.

From the viewpoint of suppressing partial discharge at the protruding portion of the adhesive layer 45 on the side of the first conductive layer 42, it is preferable to cover the end of the first conductive layer 42 with a resin layer. For example, the end of the first conductive layer 42 may be covered with the first resin layer or the second resin layer in the above-described layered body.

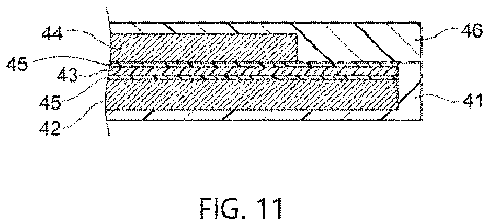

As for the layered body including a second conductive layered body, as shown in FIG. 11, the second resin layer 46 provided outside the second conductive layer 44 may be extended to the end of the second conductive layer 44. The first resin layer 41 provided outside the first conductive layer 42 may be disposed with some looseness from the end of the first conductive layer 42 so as to relieve internal stress caused by heating, as in the aforementioned layered body, or may be provided so as to cover the end of the first conductive layer 42, as shown in FIG. 11.

In the layered body of FIG. 11, after separately producing the first resin layer 41 and the second resin layer 46 in advance, one may be produced it by layering the first resin layer 41, the second conductive layered body and the second resin layer 46, or one may produce it by insert molding using the second conductive layered body.

### <Third conductive layered body>

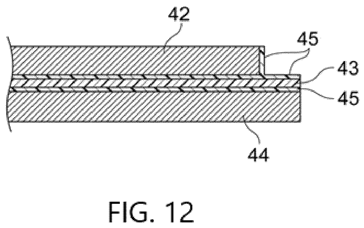

The third conductive layered body has a region at which a peripheral edge of the first conductive layer is located at an inner side relative to a peripheral edge of the second conductive layer, in which in the region, an adhesive layer is further provided on at least a part of an end face of the first conductive layer. FIG. 12 is a schematic cross-sectional view of one embodiment of the third conductive layered body.

In the third conductive layered body, the adhesive layer 45 is provided on at least a part of the end face of the first conductive layer 42, so that partial discharge from the end face of the first conductive layer 42 toward the second conductive layer 44, or partial discharge from the end face of the second conductive layer 44 toward the first conductive layer 42 is suppressed.

The adhesive layer 45 provided on at least a part of the end face of the first conductive layer 42 may the same in material as, or different from, the adhesive layer 45 provided between the first conductive layer 42 and the insulating layer 43 or between the insulating layer 43 and the second conductive layer 44.

Although FIG. 12 illustrates a form in which an adhesive layer is further provided on the end face of the first conductive layer of the second conductive layered body shown in FIG. 10, it may also be a form in which an adhesive layer is further provided on the end face of the first conductive layer of the first conductive layered body.

### <Fourth conductive layered body>

In the fourth conductive layered body, an insulating layer is further provided on an end face of at least one of the first conductive layer or the second conductive layer.

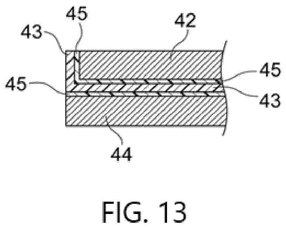

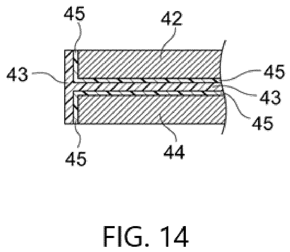

In the fourth conductive layered body, the insulating layer 43 may be provided on the end face of the first conductive layer 42 or the second conductive layer 44 as shown in FIG. 13, or may be provided on the end faces of both the first conductive layer 42 and the second conductive layer 44 as shown in FIG. 14.

By providing the insulating layer 43 on the end face of at least one of the conductive layers of the first conductive layer 42 or the second conductive layer 44, partial discharge from the end face of the first conductive layer 42 toward the second conductive layer 44, or partial discharge from the end face of the second conductive layer 44 toward the first conductive layer 42 is suppressed.

The insulating layer 43 disposed on the end face of at least one of the first conductive layer 42 or the second conductive layer 44 may be provided as a separate member from the insulating layer 43 disposed between the first conductive layer 42 and the second conductive layer 44, or it may be provided as an integral member.

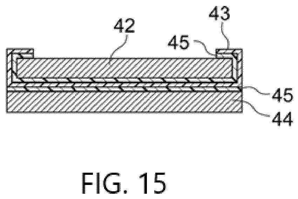

As shown in FIG. 15, the insulating layer provided on at the end face of at least one of the first conductive layer 42 or the second conductive layer 44 may further extend to a part of the outer surface of the first conductive layer.

### <Fifth conductive layered body>

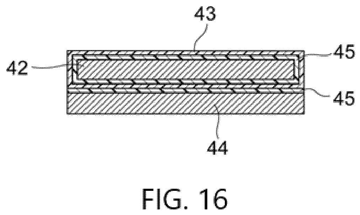

In the fifth conductive layered body, an insulating layer covers the periphery of the first conductive layer or the second conductive layer. FIG. 16 is a schematic cross-sectional view of one embodiment of the fifth conductive layered body. By employing the fifth conductive layered body structure, partial discharge from the end of the first conductive layer 42 toward the second conductive layer 44, or partial discharge from the end of the second conductive layer 44 toward the first conductive layer 42 is suppressed.

As shown in FIGS. 12 to 16, in cases where the end of the first conductive layer 42 is aligned with the end of the second conductive layer 44, or the like, it is not possible to make the distance from the end of the first conductive layer 42 around the insulating layer 43 to the second conductive layer 44 sufficiently large. Therefore, in such cases, it is preferable, from the viewpoint of more effectively preventing partial discharge, to adopt the fourth conductive layered body or the fifth conductive layered body.

### <Sixth and Seventh layered bodies>

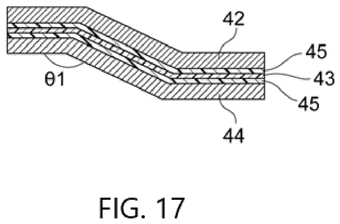

The conductive layered body may be planar as shown in FIGS. 9 to 16, or may have a bent portion that bends in the thickness direction as in the sixth conductive layered body. FIG. 17 is a schematic cross-sectional view of one embodiment of the sixth conductive layered body. In the conductive layered body, there may be one bent portion or multiple bent portions.

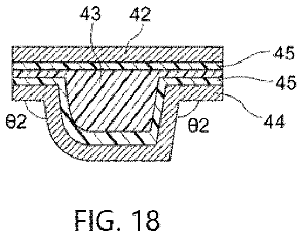

Moreover, like the seventh conductive layered body, at least one of a side of the first conductive layer or a side of the second conductive layer includes a protruding portion protruding in a thickness direction. FIG. 18 is a schematic cross-sectional view of one embodiment of the seventh conductive layered body. In FIG. 18, a part of the insulating layer 43 has been made thicker to form the protruding portion.

It is preferable that an angle θ1 of the bent portion and an angle θ2 of the protruding portion at a rising part are each independently greater than 90°. In a case in which the angles θ1 and θ2 are greater than 90°, even if voids are contained within the adhesive layer, the voids can be effectively reduced by applying pressure from the thickness direction. Additionally, in a case in which the angles θ1 and θ2 are greater than 90°, sufficient pressing is applied to each layer, thereby improving adhesion between layers and suppressing peeling between layers. Note that, in a case in which the conductive layered body is planar, angle θ1 is 180°. In cases where there is a bent portion or a protruding portion, angle θ1 or angle θ2 may be less than 180°.

Furthermore, the bent portion and the rising portion of the protrusion may be bent with a curvature or without a curvature. The same applies to other corners besides the rising portion of the protruding portion: they may be formed by bending with curvature or without curvature.

### [METHOD OF PRODUCING CONDUCTIVE LAYERED BODY]

There are no particular limitations on a method of producing a conductive layered body in the present disclosure, as long as the above-mentioned configuration can be formed. For example, one may prepare an intermediate 1 in which an adhesive layer is provided on the first conductive layer, and an intermediate 2 in which an adhesive layer is provided on the second conductive layer, then stack intermediate 1 and intermediate 2 on the insulating layer so that the adhesive layer of intermediate 1 and the adhesive layer of intermediate 2 are in contact with the insulating layer, thereby producing the conductive layered body.

### Explanation of References

10, 20, 30: Layered body
11, 21, 31, 41: First resin layer
12, 22, 32, 42: First conductive layer
13, 23, 33, 43: Insulating layer
14, 24, 34, 44: Second conductive layer
15, 25, 35, 45: Adhesive layer
16, 26, 36, 46: Second resin layer
47: Insertion portion
37: Heat-dissipating plate
100: First resin layer
101: Storage portion
102A: Concave portion
102B: Convex portion
103: Fixing portion
104: Opening portion
105: First conductive layer
106: Second conductive layer

## Claims

1. A layered body comprising, in this order:
a first resin layer;
a first conductive layer;
an insulating layer; and
a second conductive layer,
wherein the first resin layer comprises a storage portion, and the first conductive layer is disposed within the storage portion of the first resin layer.

2. The layered body according to claim 1, wherein the storage portion comprises a concave portion or a convex-concave portion.

3. The layered body according to claim 1, wherein the first conductive layer, the insulating layer and the second conductive layer are disposed within the storage portion of the first resin layer.

4. The layered body according to claim 1 or claim 2, wherein an area of the storage portion of the first resin layer is equal to or greater than an area of the first conductive layer.

5. The layered body according to any one of claims 1 to 4, further comprising a second resin layer at an opposite side of the second conductive layer from the insulating layer.

6. The layered body according to any one of claims 1 to 5, further comprising an adhesive layer between the first conductive layer and the insulating layer, and between the insulating layer and the second conductive layer, respectively,
wherein the adhesive layer comprises a resin that is solid in an environment of 25°C.

7. The layered body according to any one of claims 1 to 6, wherein the first resin layer is a cured product of a resin composition comprising a thermosetting resin.

8. The layered body according to claim 7, wherein the thermosetting resin comprises an unsaturated polyester.

9. The layered body according to any one of claims 1 to 8, wherein the first resin layer comprises a fixing portion that fixes the first conductive layer, the insulating layer and the second conductive layer.

10. A method of producing a layered body, the method comprising:
preparing a first resin layer comprising a storage portion on at least one surface; and
layering a first conductive layer, an insulating layer and a second conductive layer on a surface of the first resin layer,
wherein, in the layering, at least the first conductive layer is disposed within the storage portion of the first resin layer.

11. A conductive layered body comprising, in this order:
a first conductive layer;
an insulating layer; and
a second conductive layer,
wherein an adhesive layer is provided between the first conductive layer and the insulating layer, and between the insulating layer and the second conductive layer, respectively.

12. The conductive layered body according to claim 11, comprising a region at which a peripheral edge of the first conductive layer is located at an inner side relative to a peripheral edge of the second conductive layer,
wherein, in the region, an end of the adhesive layer at a side of the first conductive layer is aligned with an end of the first conductive layer, or is up to 10 mm longer than the end of the first conductive layer.

13. The conductive layered body according to claim 11, comprising a region at which a peripheral edge of the first conductive layer is located at an inner side relative to a peripheral edge of the second conductive layer,
wherein, in the region, an end of the adhesive layer at a side of the first conductive layer is aligned with an end of the insulating layer

14. The conductive layered body according to claim 11, comprising a region at which a peripheral edge of the first conductive layer is located at an inner side relative to a peripheral edge of the second conductive layer,
wherein, in the region, an end of the adhesive layer at a side of the first conductive layer is 20 mm or more longer than an end of the first conductive layer.

15. The conductive layered body according to any one of claims 11 to 14, wherein the adhesive layer is further provided on at least a part of an end face of the insulating layer.

16. The conductive layered body according to any one of claims 11 to 15, comprising a region at which a peripheral edge of the first conductive layer is located at an inner side relative to a peripheral edge of the second conductive layer,
wherein, in the region, the adhesive layer is further provided on at least a part of an end face of the first conductive layer.

17. The conductive layered body according to claim 11, claim 15 or claim 16, wherein the insulating layer is further provided on an end face of at least one of the first conductive layer or the second conductive layer.

18. The conductive layered body according to claim 17, wherein the insulating layer provided on the end face of at least one of the first conductive layer or the second conductive layer further extends to a part of the outer surface of the first conductive layer.

19. The conductive layered body according to claim 11, wherein the insulating layer covers a periphery of the first conductive layer or the second conductive layer.

20. The conductive layered body according to any one of claims 11 to 19, further comprising a bent portion that bends in a thickness direction, wherein an angle of the bent portion is greater than 90° and less than 180°.

21. The conductive layered body according to any one of claims 11 to 20, wherein at least one of a side of the first conductive layer or a side of the second conductive layer comprises a protruding portion protruding in a thickness direction, wherein an angle of the protruding portion at a rising part is greater than 90° and less than 180°.
